Europäisches Patentamt

European Patent Office

Office européen des brevets

(11) Publication number: **0 322 886**

**A2**

## EUROPEAN PATENT APPLICATION

(21) Application number: **88121782.2**

(22) Date of filing: **28.12.88**

(51) Int. Cl.⁴: **H01L 21/28 , H01L 21/00**

(30) Priority: **28.12.87 JP 332178/87**

(43) Date of publication of application:
**05.07.89 Bulletin 89/27**

(84) Designated Contracting States:
**DE FR GB IT**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Saita, Masami**
**91, Kasumigaoka Nishi-ku**
**Yokohama-shi Kanagawa-ken(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) **Method for manufacturing semiconductor device.**

(57) A manufacturing method for providing an LDD structure. In forming a lightly doped region of a second conductivity type opposite a first conductivity type in a semiconductor substrate of the first conductivity type around the gate electrode, diffusion of an impurity of the second conductivity type is implemented by heat processing in an oxidation atmosphere under conditions for promoting diffusion in a lateral direction so that the end of the lightly doped region of the second conductivity type reaches the portion below the gate electrode.

FIG. IC

FIG. ID

FIG. IE

FIG. IA

FIG. IB

EP 0 322 886 A2

# METHOD FOR MANUFACTURING SEMICONDUCTOR DEVICES

## BACKGROUND OF THE INVENTION

This invention relates to a method for manufacturing a MOS type semiconductor device having an LDD structure.

In MOS type semiconductor devices, as their required breakdown voltage becomes high and their structure miniaturized, LDD (Lightly Doped Drain) structures provided with a lightly doped diffused region between a heavily doped diffused layer serving as the drain region and the portion directly below the gate electrode have been employed in order to avoid the concentration of an electric field at the end of the drain region.

In a manufacturing method conventionally carried out in order to obtain such a structure, since a shallow junction is formed so as to restrain a short channel effect due to the device scaling, heat treatment after implantation of phosphoric ions for forming a lightly doped n-type region is implemented so that heat amount applied in the heat process is suppressed to as small as possble. For this reason, transistors manufactured by the above-described method are such that their lightly doped n-type region does not reach the portion directly below the end portion of the gate electrode, resulting in the tendency for them to become offset. Since current drivability becomes insufficient, failure to ensure a satisfactory output current and lowered reliability due to an increase in hot electrons take place.

As described above, conventional semiconductor devices of an LDD structure have problems in the function and the reliability resulting from the fact that the lightly doped n-type region does not reach the gate electrode end.

## SUMMARY OF THE INVENTION

Accordingly, an object of this invention is to provide a method for manufacturing semiconductor devices, which permits the provision of a semiconductor device of an LDD structure capable of ensuring sufficient current drivability and having a high reliability.

In accordance with this invention, there is provided a method for manufacturing a semiconductor device comprising the steps of forming an oxide film on a semiconductor substrate of a first conductivity type, depositing an electrode material on the oxide film, patterning the electrode material so that it has a predetermined form to thereby form a gate electrode to remove the oxide film with the gate electrode being a mask, thereby allowing the surface of the substrate to be exposed, oxidizing the exposed substrate surface, lightly doping into the substrate an impurity of an opposite conductivity type to the first conductivity type with the gate electrode being a mask, implementing heat processing in an oxidation atmosphere to thereby form a lightly doped region of a second conductivity type within the substrate around the gate electrode under the condition for promoting diffusion in a lateral direction so that the end of the lightly doped region of the second conductivity type reaches the portion below the gate electrode, depositing an insulating material on the entire surface, etching back the insulating material by anisotropic etching to form side walls on the side portions of the gate electrode, and heavily doping and diffusing the impurity of the second conductivity type with the side walls and the electrode being a mask to thereby form a heavily doped region of the second conductivity type having a concentration higher than that of the lightly doped region of the second conductivity type.

In accordance with this invention, after the conventional process for forming the lightly doped region of the second conductivity type, heat treatment is implemented under a suitable condition in an oxidation atmosphere of oxidation. Such an implementation permits the lightly doped region of the second conductivity type to definitely reach the portion below the end portion of the gate electrode without deepening the junction. Thus, insufficiency of the current drivability resulting from failure to reach that portion or lowering in reliability due to the occurrence of hot electrons can be prevented.

## BRIEF DESCRIPTION OF THE DRAWINGS

In the accompanying drawings:

FIGS. 1A to 1E are cross sectional views of an element manufacturing process sequence showing a method for manufacturing a semiconductor device of an LDD structure according to this invention; and

FIG. 2 is a graph showing the effect of this invention.

## DESCRIPTION OF THE PREFERRED EMBODIMENT

An embodiment of this invention will be described with reference to the attached drawings.

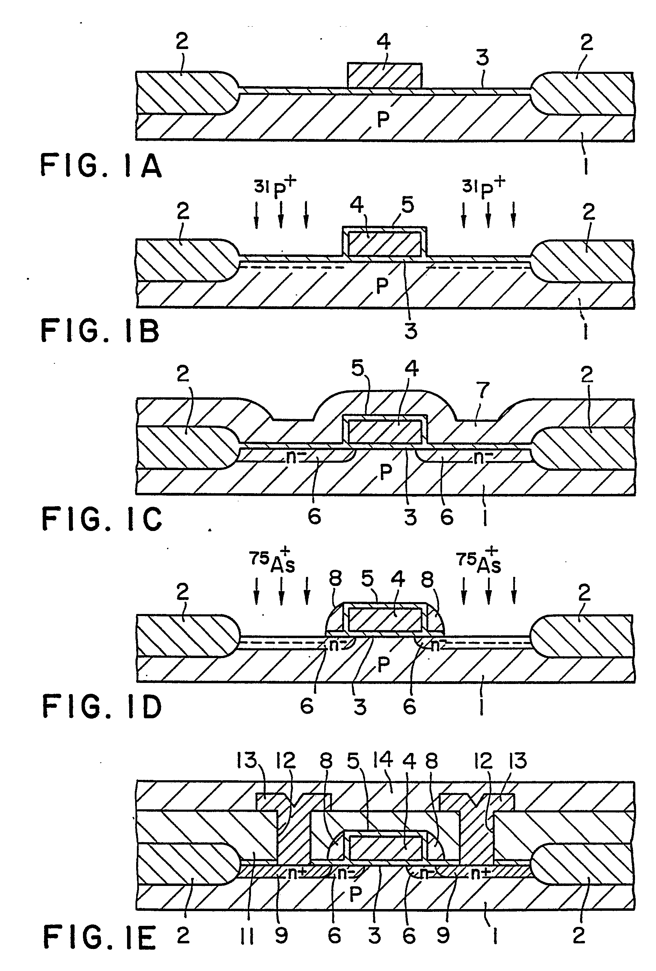

FIGS. 1A to 1E are cross sectional views of an element manufacturing process sequence showing a method for manufacturing a silicon gate n-channel MOS LDD transistor according to an embodiment of this invention.

In FIG. 1, first is to heat a p-type semiconductor substrate 1 in an oxidation atmosphere to thereby thermally oxidize the surface of the substrate 1, to therefore form a thermal oxidation film having a thickness of about 900Å. Then, a silicon nitride film (Si3N4 film) (not shown) is deposited on the entire surface and then the silicon nitride film is selectively etched to remain a region where elements are to be formed. Then an oxidation is performed to form a field oxide film 2 having a thickness of about 1 μm with the silicon nitride film being a mask. Then, the silicon nitride film in the region where elements are to be formed is removed to form a thin gate oxide film 3 having a thickness of about 500Å.

Then, ion implantation is implemented into the channel region of the transistor for control of the threshold voltage, to thereafter deposit polysilicon on the entire surface of the substrate 1 to dope and diffuse phosphorus into the polysilicon in an atmosphere of phosphoryl chloride (POCl3) to thereby provide the desired resistance value. Then, the polysilicon film is subjected to patterning by etching so that it has a predetermined form to thereby form a gate electrode 4 (FIG. 1A).

Subsequently, the oxide film 3 is removed with the gate electrode 4 being a mask to thereby allow the surface of the substrate 1 to expose after oxidation by thermal oxidation to therefore form an oxide film 5. This re-formation of the oxide film 5 is formed for the purpose of improving the breakdown voltage of the gate electrode.

Then, phosphoric ions are doped into the substrate 1 with the gate electrode 4 being a mask (FIG. 1B).

Next, diffusion by heat treatment is conducted to thereby form a lightly doped n-type (n⁻) region 6. The diffusion in this case is made by conducting heat treatment in an oxidation atmosphere within a range where the substrate current does not exceed a predetermined value and using the condition for promoting the diffusion in a lateral direction. Namely, heat is applied for 30 minutes at a temperature of 900°C in dry oxygen. Thus, as shown in FIG. IC, the lightly doped n-type region 6 extends also in a lateral direction to reach the portion below the electrode end of the gate electrode 4. Such a condition may be determined by two-dimensional simulation.

Then, a silicon oxide film 7 is deposited as an insulating material on the entire surface of the substrate 1 by the CVD method to implement etch-back by an anisotropic etching, e.g. RIE method, to allow polysilicon to remain on the side portions of the gate electrode 4, to therefore form side walls 8.

Next, arsenic (As) is ion-implanted with the side walls 8 and the gate electrode 4 being a mask (FIG. 1D) to diffuse arsenic ions to thereby form a heavily doped n-type (n⁺) regions 9 having a concentration higher than that of the lightly doped n-type region 6, and serving as source and drain regions, respectively. Also in this case, heat treatment is implemented in an oxidation atmosphere under the same conditions as above. At this time, since arsenic is an atom heavier than phosphorus, phosphoric ions in the lightly doped n-type region 6 are thrust out by the arsenic ions in the heavily doped n-type region 9. As a result, the lightly doped n-type region 6 will reach the farther internal portion below the end of the gate electrode.

After a silicon oxide film 11 is deposited as an interlayer insulating film by the CVD method, contact holes 12 are opened therein for the purposes of forming outgoing portions from the source and the drain, thus allowing the heavily doped n-type regions 9 to be exposed. Then, aluminum is vacuum-deposited on the entire surface to implement patterning thereof to thereby form wiring patterns 13 to deposit a passivation film 14 such as phospho-silicate glass (PSG) to protect the surface. A transistor having an LDD structure as shown in FIG. 1E. is therefore completed.

In such an embodiment, since the diffusion rate in the lateral direction is large under heating conditions where heat is applied at a temperature of 900°C for 30 minutes in dry oxygen, which are employed to form the lightly doped n-type region 6, the lightly doped n-type region 6 definitely reaches the portion below the electrode end of the gate electrode 4. With such a structure, the performance intrinsic to the LDD structure can be sufficiently exhibited, so that current drivability is improved and the occurrence of hot electrons reduced.

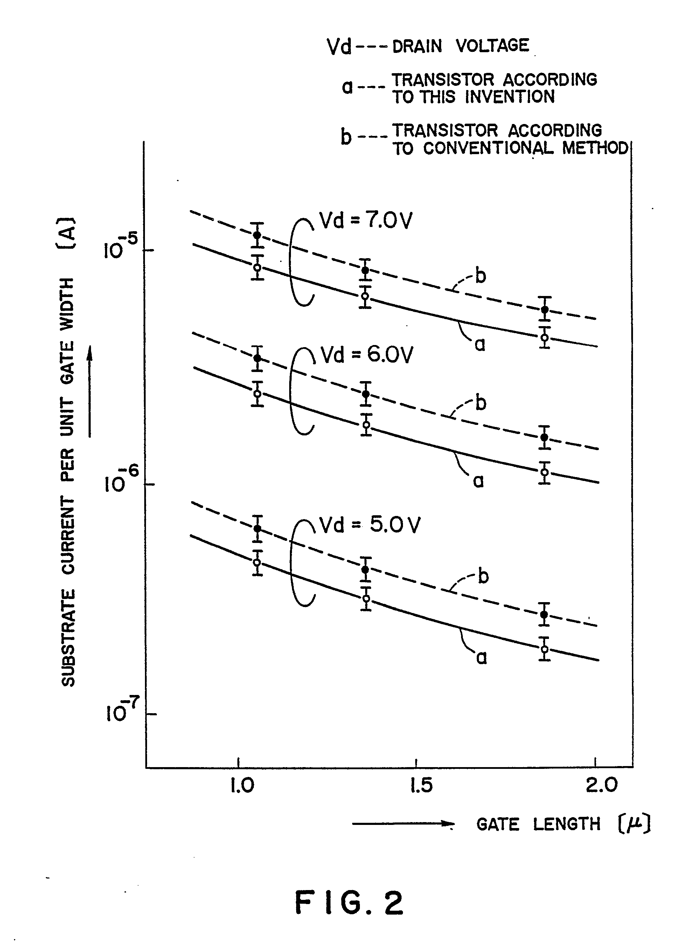

FIG. 2 is a graph showing how the substrate current value varies with respect to the gate length by using the drain voltage as a parameter wherein the broken lines indicate a conventional example and the solid lines indicate this invention.

This figure shows that the substrate current with respect to the same gate length and the same drain voltage when this invention is employed, is smaller than that in the prior art. This just means that the occurrence of hot electrons is reduced. It can be seen that the reliability is improved by this invention.

The condition for diffusing the lightly doped diffused region in the lateral direction has been illustrated in the above-described embodiment. This condition should not be considered to be restrictive. Namely, other conditions so that the lateral diffusion rate is increased without increasing the substrate current may also be employed.

In addition, it is desirable to carry out such lateral diffusion as soon as possible after ion implantation.

## Claims

1. A method for manufacturing a semiconductor device, characterized by comprising the steps of:
forming an oxide film on a semiconductor substrate of a first conductivity type;
depositing an electrode material on said oxide film;
patterning said electrode material so that it has a predetermined form to thereby form a gate electrode to remove said oxide film with said gate electrode being a mask, thereby allowing the surface of said substrate to be exposed;
oxidizing said exposed substrate surface;
lightly doping into said substrate an impurity of an opposite conductivity type to the first conductivity type with said gate electrode being a mask;
implementing heat processing in an oxidation atmosphere to thereby form a lightly doped region of a second conductivity type within said substrate around said gate electrode under the condition for promoting diffusion in a lateral direction so that the end of said lightly doped region of said second conductivity type reaches the portion below said gate electrode;
depositing an insulating material on the entire surface;
etching back said insulating material by anisotropic etching to form side walls on the side portions of said gate electrode; and
heavily doping and diffusing said impurity of the second conductivity type with said side walls and said electrode being a mask to thereby form a heavily doped region of said second conductivity type having a concentration higher than that of said lightly doped region of said second conductivity type.

2. A method as set forth in claim 1, wherein said lightly doped region of said second conductivity type is formed immediately after ion implantation.

3. A method as set forth in claim 1, wherein said lightly doped region of said second conductivity type is formed under the condition where heat is applied at a temperature of approximately 900° C for 30 minutes in dry oxygen.

FIG. IA

FIG. IB

FIG. IC

FIG. ID

FIG. IE

FIG. 2